# EUROPÄISCHE PATENTSCHRIFT

(11) **EP 2 543 082 B1**
(45) Veröffentlichungstag und Bekanntmachung des Hinweises auf die Patenterteilung: **16.11.2016**
(21) Anmeldenummer: 11707122.5
(22) Anmeldetag: 21.02.2011
(51) Int. Cl.: H01L 31/18, H01L 21/67, G01R 31/26

(54) **SERVICEEINRICHTUNG UND SERVICEVERFAHREN**
SERVICE DEVICE AND SERVICE METHOD
DISPOSITIF ET PROCÉDÉ DE SERVICE

(30) Priorität: 05.03.2010 DE 202010000325 U
(43) Veröffentlichungstag der Anmeldung: 09.01.2013
(73) Patentinhaber: KUKA Industries GmbH, 86165 Augsburg (DE)
(72) Erfinder: BECK, Dietmar, 86316 Friedberg (DE); SCHMIDT, Dieter, 86438 Kissing (DE); JAKOB, Marius, 86179 Augsburg (DE)
(74) Vertreter: Ernicke, Klaus Stefan
(86) Internationale Anmeldenummer: PCT/EP2011/052533
(87) Internationale Veröffentlichungsnummer: WO 2011/107364

(56) Entgegenhaltungen:
- EP-A1- 1 443 549
- EP-A1- 1 647 827
- JP-A- 2001 091 567
- US-A1- 2003 218 456
- US-A1- 2009 277 006

## Beschreibung

Die Erfindung betrifft eine Serviceeinrichtung und ein Serviceverfahren für Handhabungseinrichtungen von Werkstücken, insbesondere von Solarzellenanordnungen bzw. Strings, mit den Merkmalen im Oberbegriff der selbstständigen Ansprüche.

Bei der Fertigung von Solarmodulen werden Solarzellen oder andere lichtempfindliche Teile durch elektrisch leitende Bändchen untereinander verbunden und z.B. in Reihe geschaltet. Hierbei wird ein sog. String gebildet, der vor der weiteren Verarbeitung einer Prüfung unterzogen wird. Hierzu wird der String auf eine Prüfeinrichtung abgelegt und optisch auf Maßhaltigkeit und etwaige Schäden untersucht. Außerdem wird eine elektrische Spannung für die Durchgangsmessung angelegt. Anschließend wird der String wieder aufgenommen und im Assembling-Bereich einer Fertigungseinrichtung auf eine bereit gestellte Glasplatte mit einer Einbettungsfolie aufgelegt. Hierbei wird in mehreren Schritten eine Zellen-Matrix aufgebaut. Nach Auflegen weiterer Lagen, insbesondere einer weitgehend lichtundurchlässigen Rückenfolie wird das lose Sandwich anschließend in einem Laminator zu einem Photovoltaik-Modul verbacken und fixiert. Bei der Modulfertigung kann Ausschuss auftreten, der teuer ist und häufig auf die dünnen und bruchempfindlichen Solarzellen zurückzuführen ist.

Dokument EP 1647827 A1 beschreibt ein Testsystem zum Überprüfen der Fertigungsqualität von Solarzellen mit einer Prüfeinrichtung.

Es ist Aufgabe der vorliegenden Erfindung, Verbesserungsmöglichkeiten für die Fertigung von Photovoltaik-Modulen und insbesondere Solar-Zellenanordnungen bzw. Strings aufzuzeigen.

Die Erfindung löst diese Aufgabe mit einer Serviceeinrichtung und einem Serviceverfahren mit den Merkmalen in den unabhängigen Ansprüchen 1 und 15.

Die Serviceeinrichtung erlaubt es, Fehler bei der Fertigung von Solarzellen und Zellenanordnungen, insbesondere Solarstrings, rechtzeitig zu entdecken und eine Möglichkeit für Abhilfe- bzw. Nachbesserungsmaßnahmen zu bieten. Der Ausschuss wird dadurch minimiert und die Wirtschaftlichkeit der Fertigung verbessert.

Die Serviceeinrichtung erlaubt es vor allem, die sehr dünnen und mechanisch empfindlichen Solarzellen und auch deren Zellenanordnung im String, in einer Matrix oder dgl. schonend und weitestgehend berührungsfrei zu prüfen. Die Solarzellen können einzeln und auch im Verbund geprüft werden. Ferner kann ihre Relativlage zur Greifeinrichtung geprüft werden.

Die Serviceeinrichtung gestattet außerdem eine Prüfung der Handhabungseinrichtung bzw. ihrer Komponenten. Wenn hierfür ein mehrachsiger Manipulator, insbesondere ein Roboter eingesetzt wird, kann dieser sich im Betrieb durch Erwärmung, Achsentoleranzen oder andere Einflüsse verändern, was seine Positionier- und Wiederholgenauigkeit beeinträchtigen kann. Auch die vom Manipulator geführte und zum Halten der Zellenanordnung vorgesehene Greifeinrichtung kann Veränderungen unterliegen, z.B. durch Crash oder dgl. Die Prüfung der Handhabungseinrichtung bzw. ihrer Komponenten kann zeitsparend und mit geringem Aufwand ggf. im gleichen Zug mit der Zellenprüfung stattfinden.

Die Serviceeinrichtung erlaubt eine Prüfung der Solarzellen und der Zellenanordnung nach ein oder mehreren Kriterien. Dies können z.B. Form- und/oder Lagemerkmale der einzelnen Solarzellen und der Zellenanordnung sein.

Alternativ können Qualitäts- und/oder Funktionsmerkmale der Solarzellen bzw. der Zellenanordnung einer Prüfung unterzogen werden. Hierbei können insbesondere durch Anlegen einer Spannung die Zellen zur Strahlungs- bzw. Lichtemission gebracht werden, wobei bei einer solchen Elektroluminiszenzprüfung aktive und nicht aktive Zellenbereiche, insbesondere auch Mikrorisse, nicht leitende Zellenbereiche und dgl. erkannt werden können.

Die Serviceeinrichtung erlaubt es, jede Solarzelle und jede Zellenanordnung zu prüfen und die Prüfergebnisse zu dokumentieren sowie weiter zu verwerten. Hierbei kann ggf. gleichzeitig die Greifeinrichtung und/oder der Manipulator auf etwaige Fehler überprüft und korrigiert werden, z.B. durch Lagekorrektur des Tool-Center-Points (TCP) des Greifwerkzeugs. In der Folge wird die Positionsgenauigkeit und auch die Wiederholgenauigkeit des Manipulators auf einem gleichbleibend hohen Niveau gehalten.

Bei etwaigen Fehlern von Solarzellen oder einer Zellenanordnung können die defekten Teile oder Zellenanordnungen ausgeschleust und ggf. nachgebessert werden. Die Verlustraten und die damit verbundenen Kosten können minimiert werden.

Günstig ist ferner die mögliche Einbindung der Serviceeinrichtung und ihrer Komponenten in die Steuerung des Manipulators. Hierdurch kann der Steueraufwand verringert und die Schnelligkeit sowie die Präzision erhöht werden.

Die Serviceeinrichtung und ihre Prüfeinrichtung bieten eine sehr hohe Präzision dank einer Referenzeinrichtung, die eine Aufnahme von Absolutwerten in einem geeichten System erlaubt und dadurch auch eine Referenzierung des Manipulators ermöglicht. Mittels eines hochpräzisen Kalibrierteils kann die Referenzeinrichtung ihrerseits regelmäßig überprüft werden.

Die vorzugsweise optische Erfassungseinrichtung kann neben den Solarzellen bzw. Zellenanordnungen auch die Referenzeinrichtung und deren Teile erfassen und hierdurch einen exakten Lagebezug herstellen. Auch die Greifeinrichtung kann in ihrer Form und Lage gegenüber der Referenzeinrichtung überprüft werden. Die einzelnen Solarzellen oder die Zellenanordnung können in einem eigenen Achssystem beschrieben und in ihrer Lage gegenüber einer absoluten Lagevorgabe durch die Referenzeinrichtung geprüft werden. Auch die Greifeinrichtung lässt sich in einem eigenen Achssystem beschreiben und auf ihren absoluten Bezug prüfen. Hierbei können auch relative Bezüge zwischen diesen Achssystemen festgestellt und beschreiben werden. Insgesamt kann die Lage der einzelnen Solarzellen und der Zellenanordnung mit Bezug zum Lagesystem des Manipulators, insbesondere zu dessen TCP geprüft und bei Bedarf korrigiert werden. In der Folge weiß der Manipulator sehr genau, wo die Solarzellen bzw. der String angeordnet und wie deren Ausrichtung ist, so dass der Manipulator danach die Zellenanordnung, z.B. den String, mit sehr hoher Präzision bei der Weiterverarbeitung positionieren kann, insbesondere auf einer bereit gestellten Glasplatte.

Alternativ oder zusätzlich kann die Serviceeinrichtung eine Trimmeinrichtung aufweisen, die eigenständige erfinderische Bedeutung hat und die ein Trimmen von Teilen der Zellenanordnung, insbesondere der stromleitenden Verbindungen oder Bändchen an den freien Stringenden ermöglicht. Zugleich können die gekürzten Bändchen in eine vorgegebene Form und Position gebracht werden, so dass sie an der fertigen Zellen-Matrix leichter und genauer querverbunden werden können. Mit der Trimmeinrichtung kann auch eine Stromversorgung der Zellenanordnung, insbesondere zum Elektroluminiszenztest, gekoppelt sein.

Die Prüferfassung der Solarzellen und der Zellenanordnung kann in beliebig geeigneter Weise erfolgen. Vorzugsweise geschieht dies auf optischem Wege durch ein entsprechend geeignetes Erfassungsgerät, insbesondere eine Kamera, speziell eine digitale Messkamera. Mit ihr können die aufgenommenen Bilder der extern beleuchteten oder beim Elektroluminiszenztest selbst leuchtenden Solarzellen bzw. der Teilbereiche der Zellenanordnung genau vermessen und untersucht werden. Dies geschieht ohne Beschädigungsgefahr für die empfindlichen Solarzellen. Je nach Auflösungsvermögen und Messgenauigkeit des optischen Geräts kann es günstig sein, mehrere Teilbilder aufzunehmen und zu vermessen sowie diese zu einem Gesamtbild der Zellenanordnung zusammen zu setzen, z.B. im Rahmen einer Auswertung und Bildbearbeitung. Das optische Erfassungsgerät und ggf. auch eine Beleuchtungseinrichtung kann mittels einer Fördereinrichtung entsprechend an der Zellenanordnung entlang bewegt werden. Dank der miterfassten Referenzeinrichtung ist dabei auch ein genauer Lagebezug und eine entsprechend präzise Verbindung der Teilbilder möglich.

Für die optischen Prüfungen ist es günstig, die Teile der Prüfeinrichtung in einem lichtdichten Gehäuse unterzubringen, dessen Zugangsöffnung durch die Greifeinrichtung selbst geschlossen werden kann. Mit Diffusionselementen kann eine schattenfreie Beleuchtung der Zellenanordnung erreicht werden, wobei Auflicht und Durchlicht möglich ist. Durch die Lichtdichtigkeit kann auch der Elektroluminiszenztest mit hoher Präzision durchgeführt werden. Selbst kleinste Mängel an den Solarzellen und der Zellenanordnung können entdeckt werden.

Das Kalibrierteil und dessen Ausbildung mit geeigneten Anbaumöglichkeiten am Greifwerkzeug, einer Abstützungsmöglichkeit an der Prüfeinrichtung und Referenzmarkierung für Werkstücke sowie Referenzmarken für das Greifwerkzeug sind für eine hohe Präzision und für Eichmaßnahmen von Vorteil.

Insgesamt kann trotz vielfältiger Störungsmöglichkeiten und Fehlereinflüsse eine sehr hohe Ablegepräzision der Solarzellen bzw. Zellenanordnungen mit der Zuführeinrichtung erreicht werden. Auch der Ausschuss kann minimiert werden, wobei gezielte Nachbesserungsmöglichkeiten geschaffen werden. Die Prüfergebnisse können zellen- und anordnungsbezogen gespeichert, dokumentiert und als Begleitinformation bei der Weiterverarbeitung des Solarelements bzw. Photovoltaikmoduls in einem Prozesssteuerungs- und überwachungssystem mitgegeben werden.

Weitere Vorteile liegen in der hohen Wartungsfreundlichkeit der Serviceeinrichtung und der Handhabungseinrichtung. Wenn Systemkomponenten, z.B. die Kamera, die Greifeinrichtung oder der Manipulator getauscht werden, kann das gesamte System sich schnell und exakt selbst wieder referenzieren, wobei das Kalibrierteil und die Referenzeinrichtung von Vorteil sind.

Die genannten Vorteile ergeben sich vor allem bei der Fertigung und Weiterverarbeitung von Solarzellen und Zellenanordnungen, insbesondere Strings. Sie lassen sich in entsprechender Weise aber auch auf andere Arten von Werkstücken, insbesondere Anordnungen von scheibenförmigen Werkstückteilen mit Verbindungselementen, übertragen.

Von der Serviceeinrichtung und der hoch präzisen Zuführeinrichtung profitiert auch eine damit ausgerüstete Fertigungseinrichtung zur Herstellung von Solar- oder Photovoltaikmodulen oder dgl.

In den Unteransprüchen sind weitere vorteilhafte Ausgestaltungen der Erfindung angegeben.

Die Erfindung ist in den Zeichnungen beispielsweise und schematisch dargestellt. Im Einzelnen zeigen:
- Figur 1:: eine schematische Draufsicht auf eine Fertigungseinrichtung mit einer Zuführeinrichtung und einer Serviceeinrichtung,
- Figur 2:: eine schematische Ansicht einer Zuführeinrichtung zwischen einer Serviceeinrichtung und einem Assemblingbereich,
- Figur 3:: eine perspektivische Ansicht einer Greifeinrichtung,
- Figur 4:: eine Seitenansicht der Greifeinrichtung von Figur 3,
- Figur 5:: eine perspektivische Ansicht eines Kalibrierteils,
- Figur 6:: eine Seitenansicht einer Prüfeinrichtung,
- Figur 7:: eine Draufsicht auf die Prüfeinrichtung von Figur 6 gemäß Pfeil VII,
- Figur 8 und 9:: perspektivische Ansichten eines Ausschnitts VIII, IX der Prüfeinrichtung von Figur 6 mit einer Beleuchtungseinrichtung und einer Trimmeinrichtung,
- Figur 10:: eine andere perspektivische Ansicht der Trimmeinrichtung gemäß Ausschnitt X von Figur 6,
- Figur 11:: eine perspektivische Ansicht des oberen Teils der Prüfeinrichtung mit beidseitigen Trimmeinrichtungen,
- Figur 12:: eine vergrößerte perspektivische Ansicht einer Trimmeinrichtung,
- Figur 13 bis 15:: schematische Seitenansichten einer Trimmeinrichtung in verschiedenen Positionen und
- Figur 16 und 17:: eine ausschnittsweise Vergrößerung der Trimmeinrichtung am Trennbereich eines Bändchens.

Die Erfindung betrifft eine Serviceeinrichtung (11) für Zuführeinrichtungen (2) von Werkstücken (3). Sie betrifft ferner eine hierfür geeignete Handhabungseinrichtung (2). Die Erfindung befasst sich ferner mit einer Fertigungseinrichtung (1), die eine Serviceeinrichtung (11) und eine Handhabungseinrichtung (2) enthält. Zum Erfindungsgegenstand zählt ferner ein Serviceverfahren, insbesondere ein Prüf- und Trimmverfahren und ein Verfahren zur Erhöhung der Positionsgenauigkeit eines Manipulators.

Das Werkstück (3) ist in der gezeigten Ausführungsform als Solarzellenanordnung oder -formation (3) ausgebildet, die z.B. aus einer Reihe bzw. einem String von Solarzellen (4) besteht, die untereinander durch ein oder mehrere stromleitende Bändchen (5) verbunden sind. Die nachfolgenden Erläuterungen und die Ausgestaltung der Service- und Zuführeinrichtung (11,2) sowie der Fertigungseinrichtung (1) beziehen sich auf eine solche Solarzellenformation (3).

Alternativ kann das Werkstück (3) eine andere geeignete Ausbildung haben. Die Solarzellenformation (3) kann z.B. aus einer Matrix oder einer anderen Anordnung von losen oder untereinander ggf. verbundenen Solarzellen (4) bestehen. Ferner lässt sich die Erfindung auch auf andere Arten von Werkstücken (3) übertragen. Diese können z.B. aus mehreren scheibenförmigen Werkstückteilen (4) bestehen, die voneinander ggf. beabstandet sind und die untereinander durch ein oder mehrere Verbindungselemente (5) beliebiger Art verbunden sind. Bei derartigen Werkstückformationen können sich ähnliche Prüf- und Positionierprobleme wie bei den nachfolgend beschriebenen Strings oder anderen Zellenanordnungen ergeben.

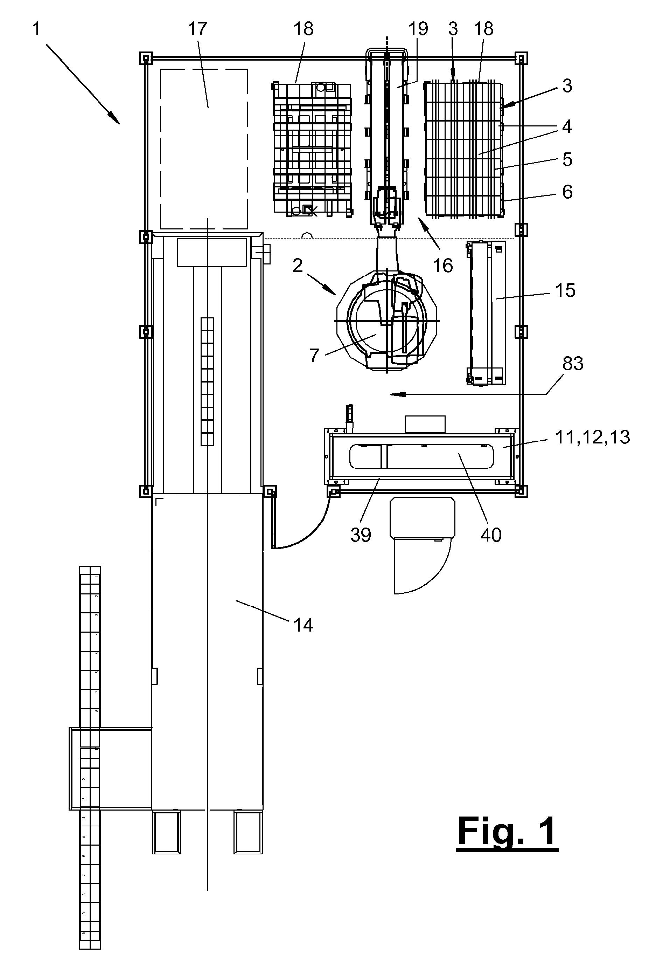

Figur 1 zeigt eine Fertigungseinrichtung (1) für Solarelemente (6). Dies können insbesondere plattenförmige Photovoltaik-Module sein, die aus mehreren übereinander angeordneten und miteinander verbundenen Lagen bestehen. Die unterste Lage kann z.B. von einer durchsichtigen Platte, insbesondere einer Glasplatte, gebildet werden. Hierauf kommt eine Einbettungsfolie, sog. EVA-Folie, zum Liegen, auf der wiederum von der Handhabungseinrichtung (2), die eine Zuführeinrichtung bildet, die Strings (3) nebeneinander unter Bildung einer Zellenmatrix aufgelegt werden. Anschließend wird eine Deckfolie, ggf. mit einer Zwischenfolie, aufgelegt. Die Deckfolie kann dunkel gefärbt und im wesentlichen lichtundurchlässig sein. Das hierdurch gebildete Sandwich aus den vorerst noch losen Lagen wird anschließend in einer Laminiervorrichtung zu einem fertigen Modul verbacken und fixiert.

Die Fertigungseinrichtung (1) weist einen sog. Stringer (14) auf, in dem ein String (3) aus mehreren in einer Reihe mit Abstand hintereinander angeordneten und durch zwei, drei oder mehr Bändchen (5) verbundenen Solarzellen (4) hergestellt wird. Die Solarzellen (4) werden z.B. durch Weichlöten der aus Kupfer, Aluminium oder einem anderen geeigneten Material bestehenden Bändchen (5) elektrisch in Reihe geschaltet. Die Solarzellen (4) können aus Wafern aus einem geeigneten Werkstoff, z.B. Silizium, bestehen.

Die Fertigungseinrichtung (1) weist ferner die Handhabungs- oder Zuführeinrichtung (2) auf. Diese besteht aus einem mehrachsigen Manipulator (7), der eine Greifeinrichtung (10) führt, mit der der String (3) an der Bereitstellung des Stringers (14) aufgenommen und gehandhabt werden kann. Im Arbeitsbereich (83) der Handhabungseinrichtung (2) und des Manipulators (7) befinden sich eine Serviceeinrichtung (11) und ggf. eine Vorzentrierung (15).

An der Vorzentrierung (15) kann der aufgenommene String (3) zunächst abgegeben, anschließend ausgerichtet und danach wieder von der Handhabungseinrichtung (2) aufgenommen werden. Die Ausrichtung ist z.B. durch eine schräge Gleitplatte mit reibungsarmer Oberfläche, z.B. durch ein Luftdüsenpolster, und mit randseitigen Anschlagkanten gebildet. Die Ausrichtung an den Anschlagkanten erfolgt durch das Eigengewicht.

Die Fertigungseinrichtung (1) weist ferner im Arbeitsbereich (83) der Handhabungseinrichtung (2) und des Manipulators (7) einen Assemblingbereich (16) auf, in dem eine oder mehrere Auflagen (18) angeordnet sein können, die zur Aufnahme der vorgenannten Teile des Solarmoduls (6) und insbesondere der Strings (3) dienen. Zwischen zwei parallelen Auflagen (18) für Wechselbetrieb kann eine Abgabe (19) angeordnet sein, an der fehlerhafte Strings (13) abgegeben und einer Nachbearbeitung zugeführt werden können, wobei sie anschließend wieder in geeigneter Weise der Handhabungseinrichtung (2) beigestellt werden, z.B. an der Abgabestelle eines Stringers (14). Ferner ist im Assemblingbereich (16) eine Zuführeinrichtung (17) für die Lagen des Solarelements (6), z.B. die Glasplatte und die Folien, angeordnet. Sie kann beispielsweise aus einem Linearroboter mit geeigneten Greifeinrichtungen bestehen, der an einem Portal über den Auflagen (18) verfahrbar ist und der eine Ausschleusstelle (nicht dargestellt) mit den Modul-Sandwiches bedient. Ferner kann die Fertigungseinrichtung auch einen Laminator (nicht dargestellt) aufzeigen, dem ggf. eine weitere Prüfeinrichtung für die Sandwiches und insbesondere die Zellenanordnung im Sandwich, vorgeschaltet ist.

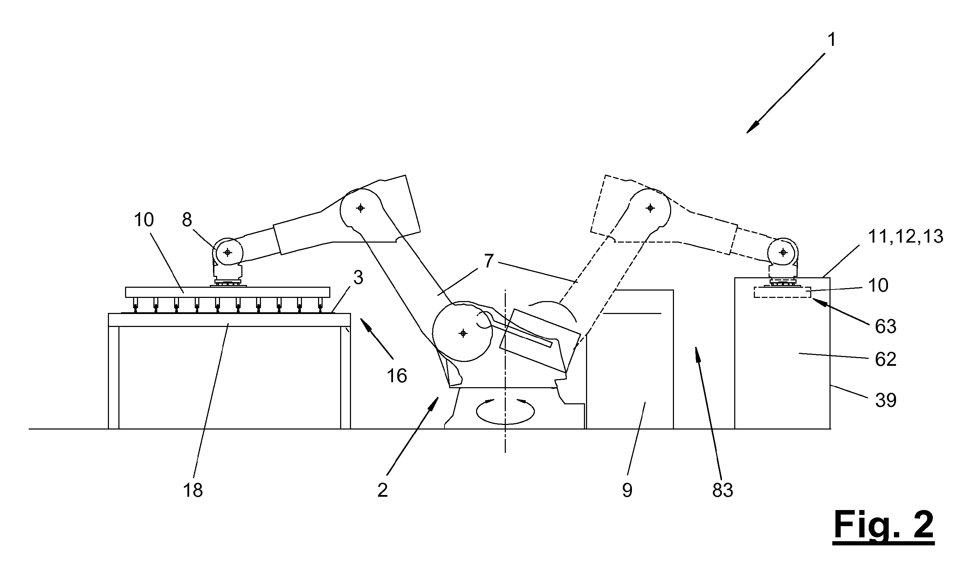

Figur 2 zeigt in einer schematischen Seitenansicht die Anordnung der Handhabungseinrichtung (2) zwischen der Serviceeinrichtung (11) und einer Auflage (18). Der mehrachsige Manipulator (7) kann eine beliebige mehrfache Zahl und Anordnung von rotatorischen und/oder translatorischen Achsen haben. Der Manipulator (7) ist vorzugsweise als programmierbarer Roboter, insbesondere als Gelenkarmroboter mit fünf oder sechs Achsen ausgebildet und weist eine Manipulator- oder Robotersteuerung (9) auf. Er kann auch eine oder mehrere Zusatzachsen, z.B. eine Fahr- oder Schwenkachse, haben.

Der bevorzugte Gelenkarmroboter hat in der gezeigten Ausführungsform sechs Achsen und besitzt ein flur- oder portalgebundenes Gestell, an dem eine Schwinge um eine Hochachse drehbar und um eine Horizontalachse schwenkbar angeordnet ist. Am Ende der Schwinge ist ein Arm oder Ausleger um eine weitere Horizontalachse schwenkbar gelagert, wobei der Arm an seinem anderen Ende eine mehrachsige Roboterhand (8) trägt. Diese kann z.B. als Zentralhand mit drei rotatorischen Achsen ausgebildet sein, die sich in einem gemeinsamen Punkt schneiden.

In Variation zur gezeigten Anordnung kann die Hand (8) nur zwei Achsen aufweisen oder eine andere Zahl und Anordnung von Achsen besitzen. Ferner kann der Manipulator (7) z.B. als Linearroboter mit einem Portal und mehreren translatorischen Achsen sowie einer abtriebseitigen Hand (8) mit mindestens einer Drehachse ausgestaltet sein.

Der Manipulator (7) kann gemäß Figur 2 zentral zwischen der Serviceeinrichtung (11) und der Auflage (18) angeordnet sein, wodurch die Schwenkbewegungen der Schwinge und des Auslegers für die vertikale Werkzeugbewegung im wesentlichen gleich sein können und die Positionsänderung durch die Drehung des Roboters um die Hochachse erfolgt. Ggf. kann wie in der gezeigten Anordnung auch die Roboterhand (8) sich um ihre Abtriebsachse drehen und das Greifwerkzeug (10) um 90° umorientieren. Mit der gezeigten Anordnung lässt sich eine sehr hohe Positionsgenauigkeit und Wiederholgenauigkeit des Manipulators (7) erzielen.

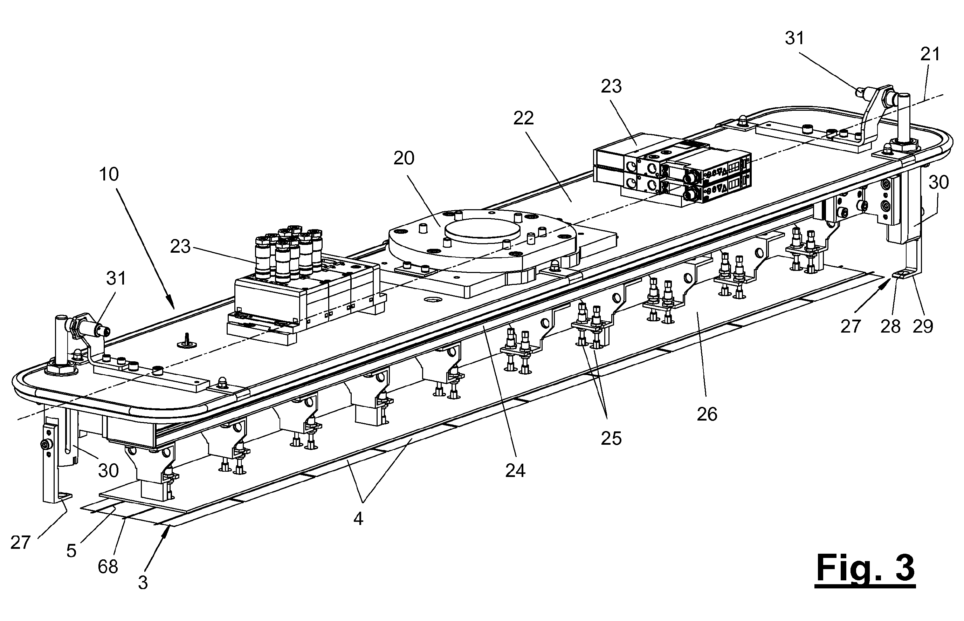

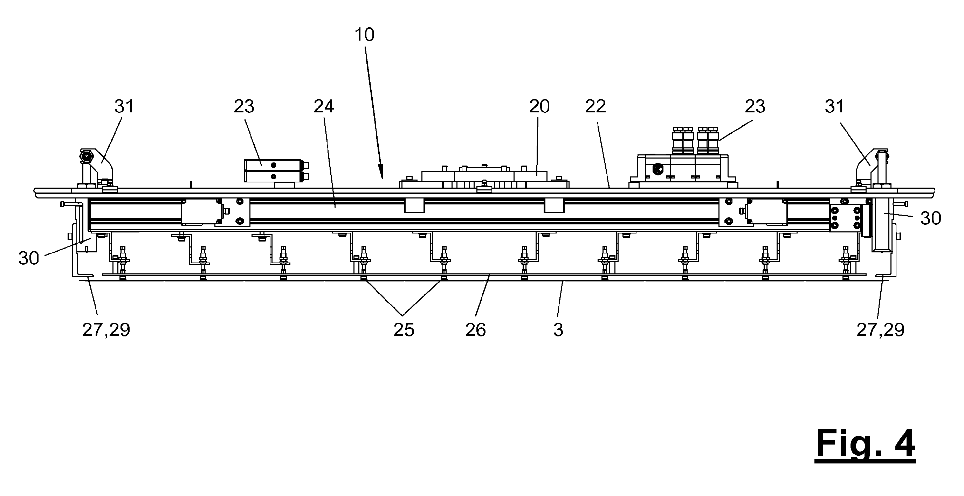

Figur 3 und 4 zeigen die Greifeinrichtung (10) mit einem aufgenommen String (3). Die Greifeinrichtung (10) weist einen Anschluss (20) zur festen oder lösbaren Verbindung, ggf. unter Zwischenschaltung einer Wechselkupplung, mit dem Abtriebsflansch der Hand (8) auf. An der Oberseite der Greifeinrichtung (10) ist eine in Längsrichtung (21) des Strings (3) sich erstreckende und an allen Seiten über den String (3) seitlich hinausragende Deckplatte (22) angeordnet. Sie trägt an der Oberseite den Anschluss (20) und kann daneben ein oder mehrere Versorgungen (23) für den Anschluss und die externe Zufuhr von Medien, insbesondere Druck- oder Saugluft, Leistungsstrom oder dgl. aufweisen. Hierüber kann auch der Signalaustausch erfolgen.

An der Unterseite der Deckplatte (22) befindet sich ein längsgerichteter Träger (24) für eine Reihe von abwärts gerichteten Greifern (25), die an Blechbügeln oder dgl. hängend angeordnet sein können. Die Greifer (25) sind z.B. als federnde Sauger ausgebildet und paarweise nebeneinander angeordnet, wobei ein Greiferpaar jeweils eine Solarzelle (4) mit Unterdruck an seiner Oberseite, vorzugsweise im zentralen Bereich, greift. Die Sauger (25) werden vom Träger (24) und der Versorgung (23) mit Unterdruck beaufschlagt.

Ferner kann die Greifeinrichtung (10) noch ein Diffusionselement (26) aufweisen, das oberhalb des Strings (3) angeordnet ist und diesen weitgehend überdeckt. Hierbei kann ein umlaufender Rand frei bleiben. Das Diffusionselement (26) kann z.B. als Diffusorplatte ausgebildet sein, die aus einem opaken und lichtdurchlässigen Material, z.B. einem Kunststoff, besteht, der das Licht einer nachfolgend erläuterten Beleuchtungseinrichtung (43) streut und für ein schattenfreies Licht sorgt. Das Diffusionselement (26) kann Ausnehmungen für die Greifer (25) und für nachfolgend erläuterte Verbindungselemente (36) eines Kalibrierteils (32) aufweisen.

Die Greifeinrichtung (10) kann ferner eine Werkzeug-Referenzmarke (27) aufweisen. Diese kann auch mehrfach vorhanden sein und befindet sich z.B. an den diagonal gegenüberliegenden Ecken der Greifeinrichtung (10) gemäß Figur 3. Die Werkzeug-Referenzmarke (27) wird von einem zum String (3) parallelen Flansch (29) mit einer definierten Durchgangsöffnung (28) gebildet, die leer sein kann oder in der ein opakes oder lichtreflektierendes Material angeordnet sein kann, welches die genaue Erfassung der Öffnungsränder zu Referenzzwecken erleichtert. Die Werkzeug-Referenzmarke (27) befindet sich jeweils an einem Stirnende des Strings (3) und ist hierzu seitlich versetzt. Sie kann in etwa auf Stringhöhe angeordnet sein. Im gezeigten Ausführungsbeispiel befindet sie sich geringfügig über dem String (3).

Der Werkzeug-Referenzmarke (27) kann eine Absteckung (30) zugeordnet sein, die z.B. einen nach unten ausfahrbaren Stößel oder Bolzen mit einem geeigneten Antrieb, z.B. einem Zylinder, aufweist. Der Bolzen kann mit dem nachfolgend erläuterten Kalibrierteil (32) in Eingriff treten. Er ist hierbei zentrisch zur Öffnung (28) und fluchtend mit deren Zentralachse ausgerichtet.

Die Greifeinrichtung (10) kann ferner eine Detektionseinrichtung (31) aufweisen. Diese kann z.B. einen oder mehrere Sensoren an einer Absteckung (30) zur Detektion von deren Funktion aufweisen. Ferner kann seitlich an oder unter der Deckplatte (22) ein Lasersensor oder dgl. angeordnet sein, der die Eintauchlage der Greifeinrichtung (10) und des Strings (3) an der nachfolgend erläuterten Serviceeinrichtung (11) detektiert.

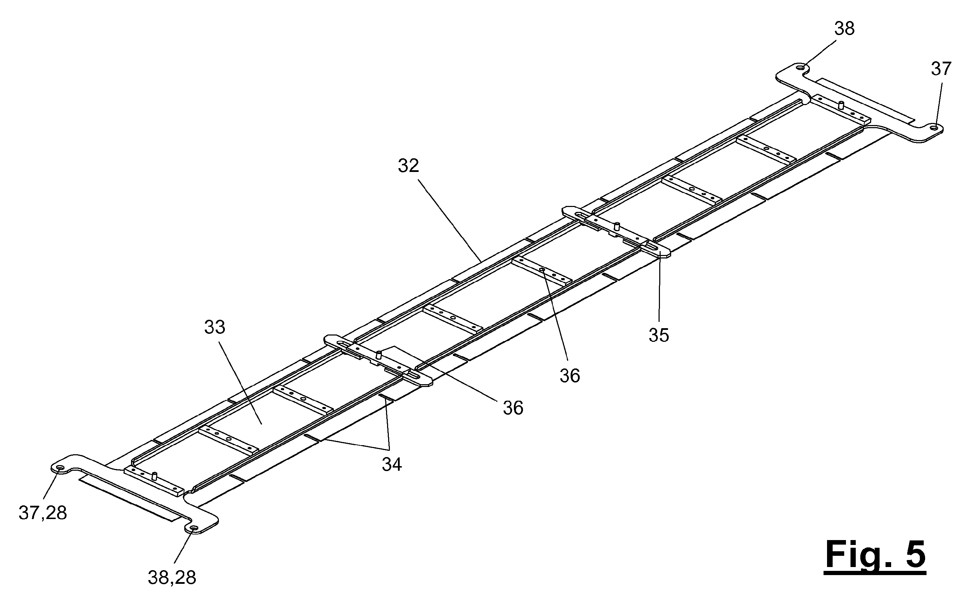

Figur 5 zeigt ein Kalibrierteil (32), welches hochpräzise gefertigt ist und zur Kalibrierung der Serviceeinrichtung (11) dient. Es weist einen in Stringlängsachse (21) sich erstreckenden Korpus (33) auf, der z.B. eine dünnwandige Plattenform haben kann, die in der Fläche umlaufend etwas größer als die Hüllkontur oder Fläche des Strings (3) ist. An der Korpusoberseite sind ein oder mehrere quergerichtete Stützelemente (35) angeordnet, die in der nachfolgend erläuterten Weise mit der Serviceeinrichtung (11) zusammenwirken und ein Durchhängen der formlabilen Platte (33) vermeiden. Ferner sind ein oder mehrere Verbindungselemente (36) vorhanden, die in der vorerwähnten Weise mit entsprechenden Aufnahmen am Träger (24) bzw. seinem Bügel verbunden werden können. Dies kann z.B. durch Schrauben, fernsteuerbare Verschlüsse oder dgl. geschehen. Durch die Verbindungselemente (36) kann bei entferntem String (3) das Kalibrierteil (32) in der gleichen oder einer ähnlichen Höhenlage wie der String (3) an der Greifeinrichtung (10) lösbar befestigt werden.

Ferner weist das Kalibrierteil (32) eine Referenzmarkierung (34) für die einzelnen Solarzellen (4) und/oder den String (3) auf. Die Referenzmarkierung (34) ist exakt auf die Soll-Form und die Soll-Lage der Solarzellen (4) und des Strings (3) positioniert und besteht z.B. aus Linien, Winkeln oder anderen geeigneten Markierungselementen. Beispielsweise sind mehrere rechtwinklig zusammenstoßende Linienmarken mit gegenseitigem Abstand auf der linken und rechten Plattenunterseite vorhanden, welche die Eckbereiche der üblicherweise rechteckigen Solarzellen (4) und die vorgesehenen Zellenabstände markieren. Weitere Markierungslinien oder dgl. können für die Bändchen (5) vorhanden sein.

Am Kalibrierteil (32) sind ferner eine Referenzmarke (37) für die Greifeinrichtung (10) und eine Referenzmarke (38) für die Kalibrierposition in der Serviceeinrichtung (11) angeordnet. Diese Marken (37,38) können mehrfach vorhanden sein. Sie können in beliebiger Weise ausgebildet sein und bestehen z.B. ähnlich wie die Werkzeug- Referenzmarke (27) aus definierten Öffnungen (28), die an abgewinkelten Armen an den Stirnseiten des Korpus (33) angeordnet und dabei zumindest seitlich vom Korpus (33) beabstandet sind. Die vier Öffnungen (28) können untereinander gleich sein. Zwei diagonal zueinander versetzte Öffnungen (28) korrespondieren mit den Absteckungen (30) der Greifeinrichtung (10). Bei korrekter und unbeschädigter Greifeinrichtung (10) dringen die Stößel der Absteckungen (30) zwängungsfrei durch die besagten Öffnungen (28) des Kalibrierteils (32). Andernfalls wird ein Greiferschaden über die Detektionseinrichtung (31) festgestellt und signalisiert.

Das Kalibrierelement (32) kann an geeigneter Stelle im Arbeitsbereich (23) des Manipulators (7) bereitgehalten werden. Es kann manuell montiert oder mit einer geeigneten Verbindungseinrichtung automatisch und ferngesteuert aufgenommen und wieder abgegeben werden.

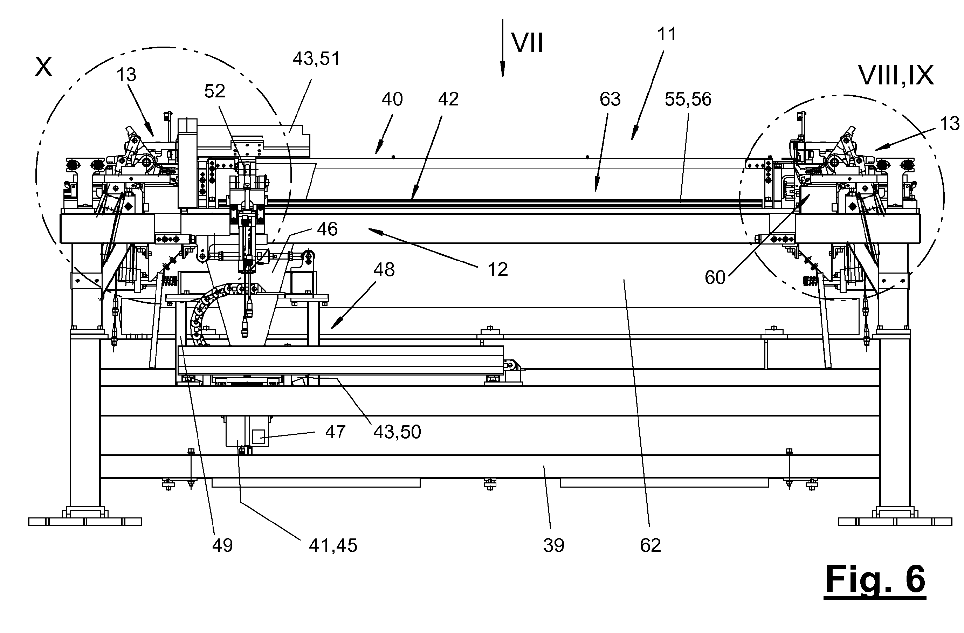

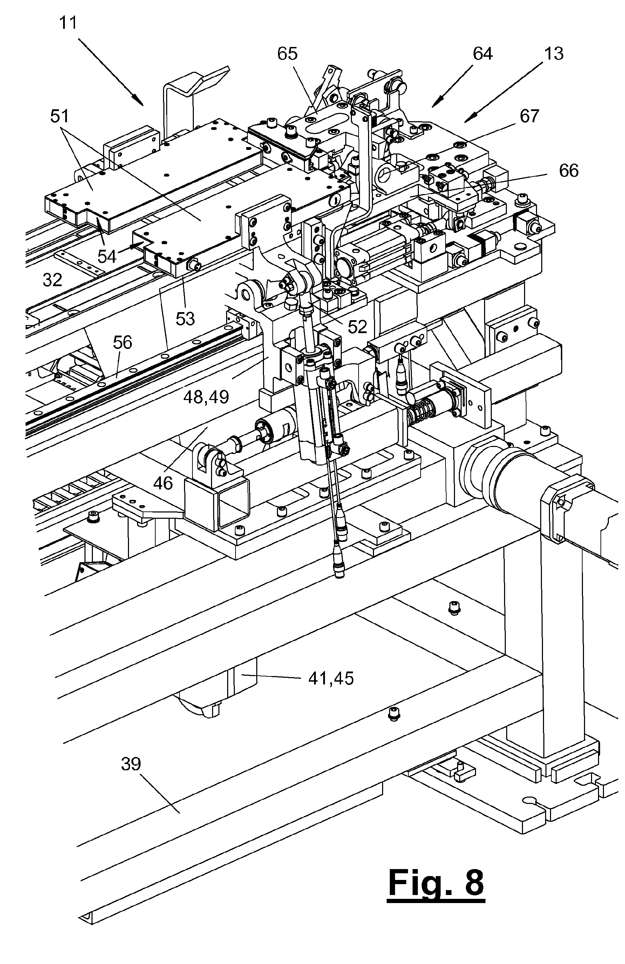

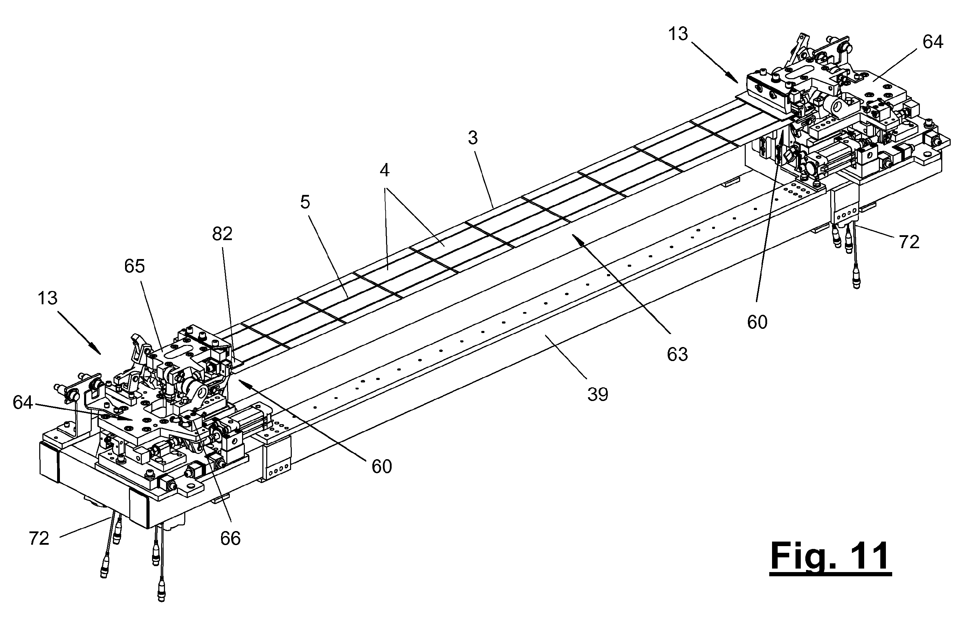

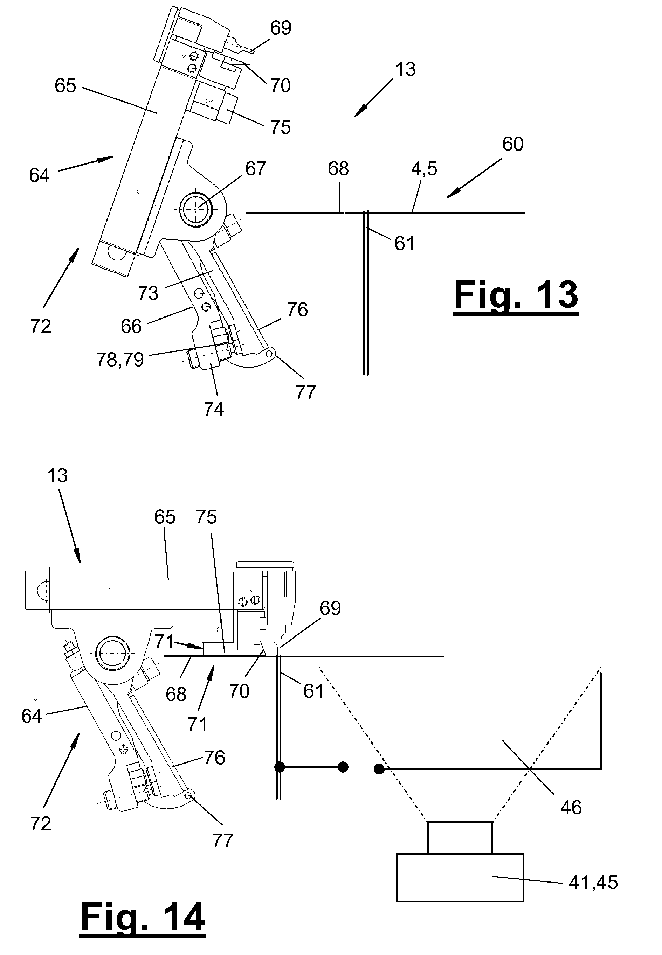

Die nachfolgend unter Bezugnahme auf Figur 6 bis 14 erläuterte Serviceeinrichtung (11) weist eine Prüfeinrichtung (12) und/oder eine Trimmeinrichtung (13) auf, auf welche nachfolgend näher eingegangen wird. Die Prüfeinrichtung (12) dient zur Prüfung des Strings (3) und der Zuführeinrichtung (2).

Die Prüfeinrichtung (12) kann in unterschiedlicher Weise ausgebildet sein. Sie kann zum Prüfen von ein oder mehreren Kriterien dienen. Dies kann einerseits Form- und/oder Lagemerkmale des Strings (3) und andererseits dessen Qualitäts- und/oder Funktionsmerkmale betreffen. Die Prüfeinrichtung (12) kann auch eine Ausbildung zum optischen Prüfen eines von außen beleuchteten und/oder selbstleuchtenden bzw. luminiszierenden Strings (3) dienen. Ferner kann die Prüfeinrichtung (12) eine Ausbildung zum Prüfen von Veränderungen der Handhabungseinrichtung (2) aufweisen. Dies kann insbesondere Schäden und/oder Positionierfehler der Greifeinrichtung (10) und/oder des Manipulators (7) betreffen.

Bei der Verarbeitung der dünnen und bruchempfindlichen Solarzellen (4) im Stringer (14) können Fehler auftreten, die die Qualität, insbesondere das Aussehen und die Leistung, des Solarmoduls (6) verschlechtern. Beispielsweise betrifft dies einen Zellenbruch, Verbindungsfehler, wie fehlende, lose oder verdrehte Lötbändchen (5), Strings mit fehlerhafter Geometrie, wie z.B. ungleichmäßige Zellenabstände, Zellenverdrehungen, Lageverschiebungen von Solarzellen in Bogen- oder Wellenform, sog. Bananenstrings, oder dgl.. Formfehler können Abweichungen in Form und Größe sowie ggf. Wölbung der Solarzellen (4) sein. Funktions- und Qualitätsfehler können den Stromdurchgang der Solarzellen (4) und des Strings (3) und/oder die Leistungsfähigkeit der einzelnen Solarzellen (4) betreffen. Solarzellen (4) können beispielsweise elektrisch nicht leitende Bereiche oder Haarrisse im Wafer haben. Auch die elektrische Leitfähigkeit der Bändchen (5) kann betroffen sein.

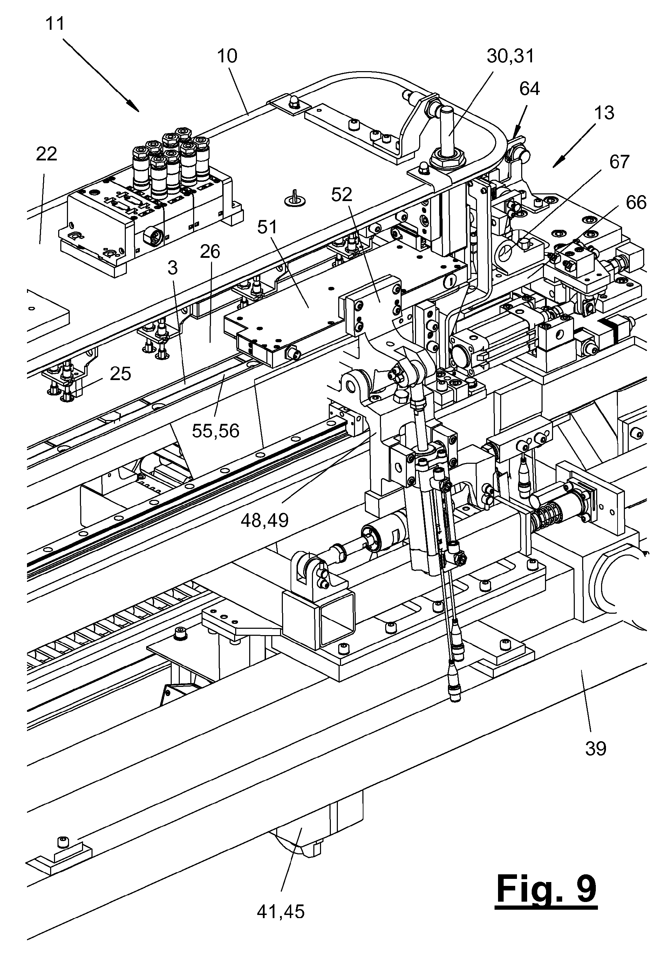

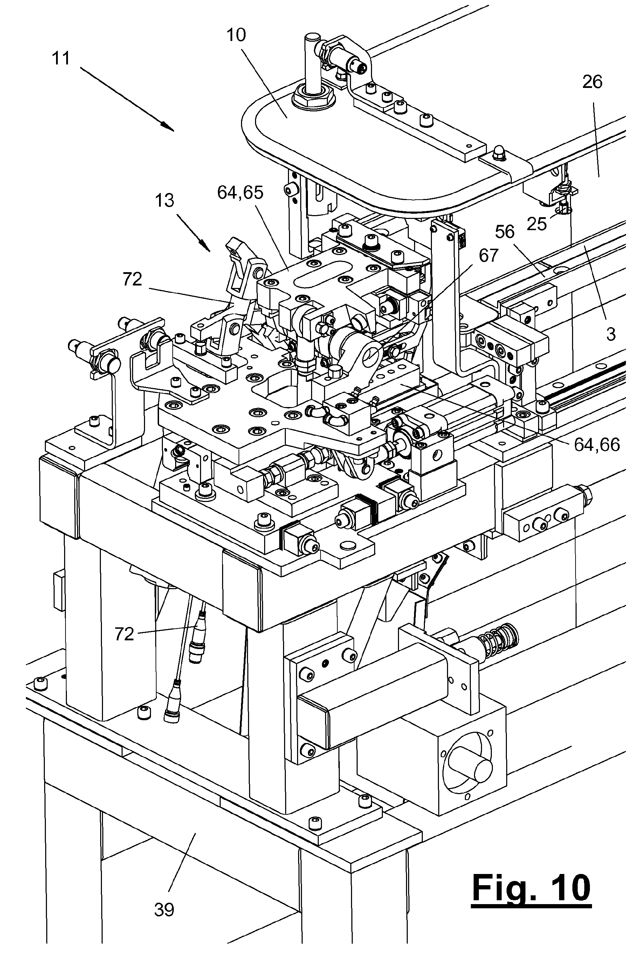

Die Serviceeinrichtung (11) kann gemäß Figur 6 ein Gehäuse (39) mit einem Innenraum (62) und einem dortigen Aufnahmebereich (63) zur Aufnahme des von der Handhabungseinrichtung (2) schwebend gehaltenen Strings (3) und eines Teils der Greifeinrichtung (10) aufweisen. Figur 6 bis 8 zeigen die Serviceeinrichtung (11) mit einem Kalibrierteil (32). In den Ausschnittsvergrößerungen von Figur 9 und 10 ist ein Teil der Greifeinrichtung (10) dargestellt.

Das Gehäuse (39) kann geschlossene Wände und eine vorzugsweise obenliegende Zugangsöffnung (40) aufweisen. Je nach Art der Prüftechnik kann es sinnvoll sein, das Gehäuse (39) gegen Lichtzutritt von außen abzudichten. Dies kann z.B. durch die Deckplatte (22) der Greifeinrichtung (10) geschehen, welche die Zugangsöffnung (40) überdeckt und schließt. Je nach Prüftechnik kann das Gehäuse (39) alternativ aus einem zumindest bereichsweise offenen Gestell bestehen. Im Gehäuse (39) können die Prüfeinrichtung und/oder die Trimmeinrichtung (13) untergebracht sein.

Die Prüfeinrichtung (12) weist eine Erfassungseinrichtung (41) für den String (3) und/oder die Greifeinrichtung (10) auf. Ferner ist im Erfassungsbereich der Erfassungseinrichtung (41) eine Referenzeinrichtung (42) angeordnet. Die Prüfeinrichtung (12) kann ferner eine Beleuchtungseinrichtung (43) für den String (3) und ggf. die Greifeinrichtung (10) aufweisen. Die Prüfeinrichtung (12) kann im weiteren eine Versorgungseinrichtung (44) ,z.B. eine Stromversorgung, für den String (3) haben, die einen Elektroluminiszenztest ermöglicht.

Die Erfassungseinrichtung (41) kann in beliebig geeigneter Weise ausgebildet sein und die vorgenannten Form-, Lage-, Qualitäts- und/oder Funktionsmerkmale der Solarzellen (4) und des Strings (3) sowie ggf. der Greifeinrichtung (10) physikalisch erfassen. In der bevorzugten und gezeigten Ausführungsform erfolgt die Erfassung auf optischem Wege. Sie kann alternativ durch elektromagnetische Strahlung, Ultraschall oder auf andere geeignete Weise, ggf. auch durch Mischung verschiedener Erfassungstechniken, erfolgen.

In der gezeigten Ausführungsform weist die Erfassungseinrichtung (41) ein optisches Erfassungsgerät (45) auf, welches z.B. als Kamera, insbesondere als digitale Messkamera, ausgebildet ist. Das optische Erfassungsgerät (45) kann Bilder vom String (3) und der Greifeinrichtung (10) aufnehmen und mittels einer integrierten oder externen Auswerteeinrichtung (47), z.B. mit einer Bildauswertung, verarbeiten. Hierbei können die erfassten Bildbestandteile in ihrer Lage, Form, Größe sowie gegenseitigen Zuordnung vermessen werden. Hierbei können die äußeren Konturen der Solarzellen (4) und der Verbindungselemente (5) sowie deren Abstände und auch die inneren Strukturen, z.B. gleichmäßige oder durch Risse unterbrochene Flächen, der Solarzellen (4) optisch erfasst und ausgewertet werden, wobei etwaige Fehler, wie Risse oder dgl., nach Lage, Form und Größe innerhalb der Zellenfläche ermittelt werden können. Die ausgewerteten Daten können der einzelnen Solarzelle (4) und dem String (3) in einem übergeordneten Steuer- und Überwachungssystem zugeordnet und als Begleitinformation in einem entsprechenden Datensatz gespeichert werden.

Das optische Erfassungsgerät (45) ist z.B. unterhalb des Aufnahmebereichs (63) angeordnet und hat eine Blickrichtung nach oben, wobei in seinem Sichtbereich (46) einer oder mehreren Solarzellen (4) und Teilen der Greifeinrichtung (10) auch Teile der Referenzeinrichtung (42) liegen. Über diese gemeinsame Erfassung kann ein relativer und ggf. ein absoluter Lagebezug der vorgenannten Merkmale hergestellt werden. Dies kann ein Lagebezug der Solarzellen (4) im String (3), aber auch ein Lagebezug der Solarzellen (4) und des Strings (3) gegenüber der Greifeinrichtung (10) sein. Ferner kann bei entsprechender Eichung der Referenzeinrichtung (42) ein absoluter Lagebezug gegenüber einem zentralen Koordinatensystem, z.B. einem World-Koordinatensystem des Manipulators (7) oder auch der Fertigungseinrichtung (1) hergestellt werden.

Je nach Auflösungsvermögen des optischen Erfassungsgeräts (45) können die Gesamtheit oder Teile des Strings (3) und ggf. der Greifeinrichtung (10) im Sichtbereich (46) erfasst werden. Mit aktuell verfügbaren Kamerasystemen ist es aus Auflösungsgründen günstig, mehrere Teilbilder von solchen Bereichen aufzunehmen und anschließend mit einer Bildbearbeitung unter Hilfe der Referenzeinrichtung (42) zusammenzusetzen. Hierfür kann das optische Erfassungsgerät (45) mit einer Fördereinrichtung (48) verbunden sein, die z.B. einen längs des Strings (3) verfahrbaren Schlitten oder anderen Träger (49) aufweist. Hierbei werden vom optischen Erfassungsgerät (45) aufeinander folgende und randseitig einander überlappende Teilbilder aufgenommen, die anhand gemeinsamer Referenzmerkmale im Überlappungsbereich exakt zu einem Gesamtbild zusammengesetzt werden können.

Die vorerwähnte Beleuchtungseinrichtung (43) kann den String (3) und dessen Teile extern beleuchten. Dies kann mit Auflicht und/oder mit Durchlicht geschehen. Für eine Auflicht-Betrachtung der Stringunterseite kann dem optischen Erfassungsgerät (45) ein stationäres oder ggf. von der Fördereinrichtung (48) bzw. deren Träger (49) mitbewegtes Beleuchtungsgerät (50) zugeordnet sein, welches z.B. aus einer das Kameraauge umgebenden Ringleuchte bestehen kann. Eine schattenfreie Beleuchtung kann durch ein vorgeschaltetes Diffusionselement (53) oder auf andere geeignete Weise erfolgen. Das Beleuchtungsgerät (50) strahlt in Blickrichtung der Kamera (45) nach oben.

Für eine Durchlicht-Beleuchtung können über dem String (3) ein oder mehrere obere Beleuchtungsgeräte (51) stationär oder mittels der Fördereinrichtung (48) bzw. des Trägers (49) mitbewegt angeordnet sein. Die Beleuchtungsgeräte (51) können z.B. paarweise und beidseits des Strings (3) angeordnet sein, wobei sie mittels einer Zustellvorrichtung (52), z.B. einer Schwenkeinheit, in den seitlichen Freiraum der Greifeinrichtung (10) und möglichst weit zu deren Mitte bewegt werden können. Das oder die oberen Beleuchtungsgeräte (51) können für eine weitestgehend gleichmäßige und die gesamte Stringfläche erfassende Beleuchtung sorgen. Hierfür können sie z.B. Leuchtelemente (54) aufweisen, die z.T. nach unten und z.T. schräg zur Stringmitte hin strahlen, wobei ggf. zur Schattenvermeidung ein Diffusionselement (53) vorgeschaltet ist. Derartige Leuchtelemente (54) können geeignete LEDs sein, die auch beim unteren Beleuchtungsgerät (50) eingesetzt werden können.

Die unteren und/oder oberen Beleuchtungsgeräte (50,51) können im sichtbaren und ggf. im unsichtbaren Lichtbereich, insbesondere im Infrarotbereich strahlen. Hierfür können ein oder mehrere entsprechend geeignete Leuchtelemente (54) vorgesehen sein. Das optische Erfassungsgerät (45) kann ggf. ein breites Empfindlichkeitsspektrum für unterschiedliche Wellenlängen des emittierten Lichtes haben und insbesondere neben dem sichtbaren Lichtbereich auch Infrarotlicht oder andere weniger gut für das menschliche Auge sichtbare Wellen- bzw. Strahlungsbereiche erfassen. Unter Umständen kann das optische Erfassungsgerät (45) auch aus mehreren Komponenten für verschiedene Wellen- und Strahlungsbereiche ausgebildet sein. Mit dem optischen Erfassungsgerät (45) können neben Bildern mit Auflicht und/oder Durchlicht auch Bilder mit Elektroluminiszenz der durch Spannungsanlegung selbst leuchtenden Solarzellen (4) aufgenommen werden. Hierbei können je nach Lichtart mehrere unterschiedliche Bilder aufgenommen und getrennt voneinander mit anderen gleichartigen Teilbildern zusammengesetzt werden. Auch die Bildauswertung kann gemeinsam oder getrennt erfolgen.

Die Referenzeinrichtung (42) kann stationärer und ggf. instationärer Natur sein. Eine stationäre Komponente kann z.B. aus einer oder mehreren Referenzmarkierungen (55) bestehen, die neben dem Aufnahmebereich (63) des Strings (3) und ggf. der Greifeinrichtung (10) ortsfest im Gehäuse (39) angeordnet sind. Sie liegen im Sichtbereich (46) des optischen Erfassungsgeräts (45) und können in beliebig geeigneter Weise ausgebildet sein. Die Referenzmarkierung (55) kann z.B. beidseits des schwebend gehaltenen Strings (3) und in dessen Längsrichtung (21) parallel sich erstreckende Lochleisten (56,57) aufweisen. Die Lochleisten (56,57) haben eine Vielzahl von definierten Löchern (58), die genau gefertigt und an definierten Stellen angeordnet sein können. Dank der Erfassungseinrichtung (41) und einer Referenzmarke (59) im Gestell (39) mit genauer absoluter Position braucht die Leistenfertigung alternativ nicht genau zu sein. Die Lochreihen in den beidseitigen Leisten (56,57) können gegenseitig versetzt und auf Lücke angeordnet sein. Die Lochverteilung ist vorzugsweise derart, dass im Sichtbereich (46) und ggf. bei jedem Teilbild mindestens drei Löcher (58) erfasst werden, um eine Teilbildzuordnung im Überlappungsbereich sicher zu stellen.

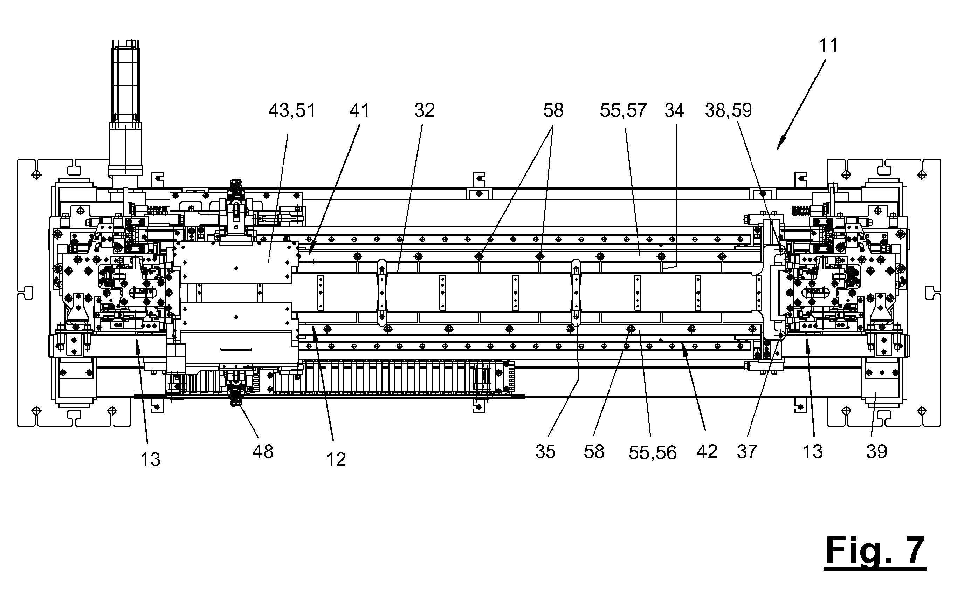

Die Referenzeinrichtung (42) kann ferner die vorerwähnte stationäre Referenzmarke (59) für ein Kalibrierteil (32) aufweisen. Die in Figur 7 angedeutete Referenzmarke (59) kann ebenfalls im Erfassungs- bzw. Sichtbereich (46) des optischen Erfassungsgeräts (45) angeordnet sein und kann eine exakt vermessene Position haben, deren Koordinaten in einem übergreifenden Koordinatensystem, z.B. im World-Koordinatensystem des Manipulators (7) oder dgl. beschrieben sind. Die Referenzmarke (59) kann ein im Gehäuse (39) montierter Arm mit einer Öffnung oder dgl. ähnlich der vorbeschriebenen Öffnung (28) sein. Statt einer Öffnung können in allen beschriebenen Ausführungsformen der Marken oder Markierungen auch andere geeignete Elemente wie Kegel oder dgl. benutzt werden.

Mit der Erfassungseinrichtung (41) kann unter Bezug auf die Lochleisten (56,57) festgestellt werden, wie die äußere Form und die innere Struktur der Solarzellen (4) aussieht und wo die Solarzellen (4) sich im String (3) befinden. Ferner können ihre Relativbezüge, insbesondere die gegenseitigen Abstände und etwaige Versätze erfasst werden.

Über die Lochleisten (56,57) und die Werkzeug-Referenzmarke(n) (27) kann auch der Lagebezug der Greifeinrichtung (10) festgestellt werden. Ggf. kann hierfür auch die ebenfalls in einem definierten Lagebezug zur Referenzmarkierung (45) stehende Referenzmarke (59) benutzt werden. Über diese Lagebezüge können in der vorerwähnten Weise Achssysteme für den String (3) und die Greifeinrichtung (10) gebildet und in gegenseitigem Bezug sowie im Bezug zur Absolutposition gesetzt werden. Hierbei kann die Relativlage des Strings (3) und seiner Solarzellen (4) zur Greifeinrichtung (10) und die Relativlage oder Absolutlage der Greifeinrichtung (10) zu einem externen Bezug festgestellt werden. Etwaige Achstoleranzen oder Formänderungen durch Erwärmung etc. des Manipulators (7) können für eine Fehlposition der vom Manipulator (7) in einer vorprogrammierten Stellung im Aufnahmebereich (63) gehaltenen Greifeinrichtung (10) sorgen. Diese kann über die genannten Lagebezüge festgestellt und zur Korrektur der Manipulatorbewegungen , insbesondere zur Korrektur des TCP, herangezogen werden.

Zum Eichen der Referenzeinrichtung (42) kann das Kalibrierteil (32) an der Greifeinrichtung (10) eingesetzt werden, das mit seiner Referenzmarke (38) für die Kalibrierposition vom Manipulator (7) unter Mitwirkung der Erfassungseinrichtung (41) in exakte Position zur Referenzmarke (59) im Gestell (39) gebracht wird, wobei z.B. die gleiche Form und Größe aufweisenden Öffnungen zur fluchtenden Deckung übereinander gebracht werden. Anhand der Referenzmarkierung (34) für den String (3) und ggf. der Referenzmarke (37) für das Greifwerkzeug (10) können dann die Referenzmarkierung (55) und insbesondere deren Lochleisten (56,57) mit Bezug zum Kalibrierteil (32) und zum Grundbezug mit der Referenzmarke (59) vermessen werden.

Das Kalibrierteil (32) kann sich bei dieser Vermessung mit den ggf. ausfahrbaren Stützelementen (35) auf den seitlichen Lochleisten (56,57) abstützen. Figur 7 zeigt diese Anordnung.

Die Prüfeinrichtung (12) kann einen im Bereich, insbesondere an beiden Stirnenden des Aufnahmebereichs (63) liegenden Versorgungsanschluss (60) für den String (3) aufweisen, der z.B. als Stromanschluss ausgebildet ist und eine elektrisch leitende und an eine schaltbare und ggf. steuerbare Stromquelle angeschlossene Auflage (61) für die stirnseitig überstehenden Bändchen (5) aufweist. Der Versorgungsanschluss (60) kann Bestandteil der nachfolgend erläuterten Trimmeinrichtung (13) sein.

Die Trimmeinrichtung (13) ist für Werkstückteile, insbesondere für die Verbindungselemente (5) an den beiden Stirnenden des Strings (3) vorgesehen. Sie weist einen Trimmkopf (64) auf, der zum Fixieren, Kürzen und Aufbereiten von einem Überstand (68) der Bändchen (5) dient. Hierbei kann der Trimmkopf (64) mit dem Versorgungsanschluss (60) bzw. der Auflage (61) zusammenwirken.

Der Trimmkopf (64) kann beweglich sein und erlaubt eine Zustellung seiner Komponenten an den String (3) und die Überstände (68) in einer vorbestimmten Weise. Diese Zustellung ermöglicht ähnlich wie bei der Beleuchtungseinrichtung (43) ein Positionieren und Entfernen des Strings (3) und der Greifeinrichtung (10) im Aufnahmebereich (63).

Der Trimmkopf (64) kann ein Oberteil (65) und ein Unterteil (66) aufweisen, die getrennt voneinander beweglich und zustellbar sind. Die Kinematik kann beliebig gewählt sein, wobei die Kopfteile (65,66) beispielsweise über eine gemeinsame Achse (67) schwenkbar gelagert sind. Eine geeignete Zustellvorrichtung (72) mit ein oder mehreren steuerbaren Antrieben kann für die gesteuerte Kopfbewegung sorgen.

Am Oberteil (65) oder an anderer geeigneter Stelle kann ein zustellbares Trennelement (70) angeordnet sein, welches z.B. als Messer ausgebildet ist und ein oder mehrere Bändchen (5) an einer vorgegebenen Stelle durchtrennt. Ferner kann am Oberteil (65) oder an anderer geeigneter Stelle ein elektrisches Kontaktelement (69) angeordnet sein, welches mit der darunterliegenden Auflage (61) zusammenwirkt und für ein elektrisch leitendes und kontaktierendes Einspannen von ein oder mehreren Bändchen (5) in der Schließstellung sorgt. Das Kontaktelement (69) kann z.B. federnd gelagert sein und aus einem Federstößel bestehen.

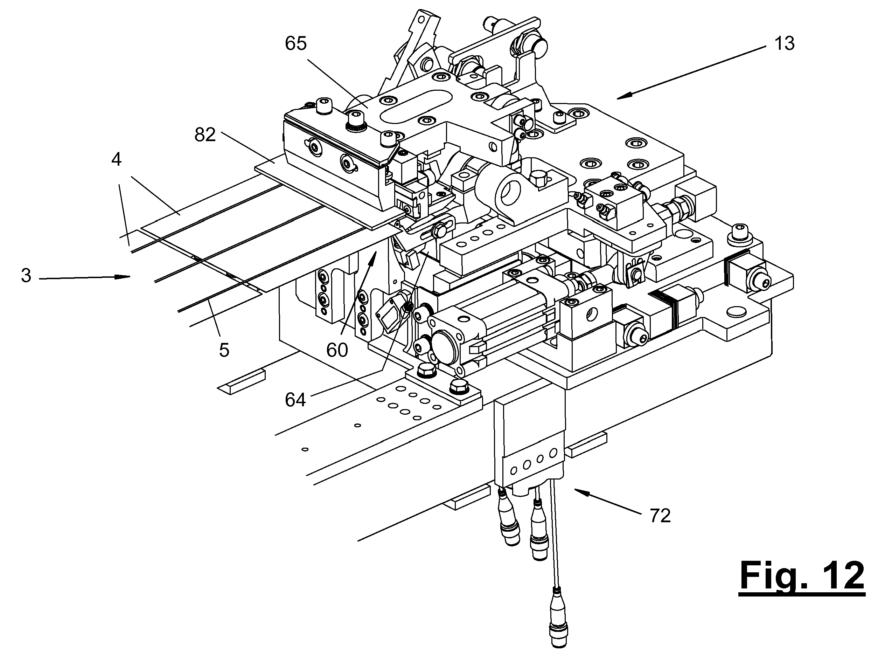

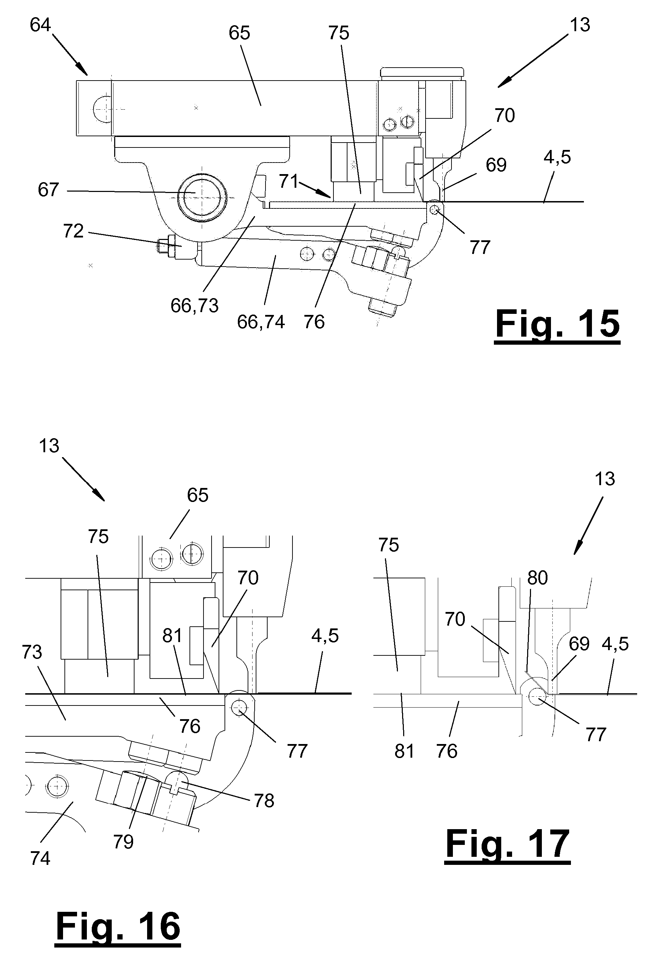

Figur 12 bis 17 zeigen die Anordnung, Ausbildung und Funktion der Trenneinrichtung (13).

Für die Elektroluminiszenzprüfung wird zunächst das Kontaktelement (69) auf die auf der Auflage (61) liegenden Bändchen (5) gedrückt, um für eine gleichmäßige Spannungs- und Stromversorgung zu sorgen. Nach Abschluss der Prüfung der Solarzellen (4) und des Strings (3) werden die Bändchen (5) gekürzt. Hierfür wird das zunächst noch abgeschwenkte Unterteil (66) nach oben bewegt. Es weist einen Gegenhalter (76) auf, der plattenförmig ausgebildet sein kann und der in der Endstellung eine Horizontallage einnimmt, wobei er einerseits eine Schneidplatte für das Zusammenwirken mit dem Trennelement (70) bildet. Andererseits kann der Gegenhalter (76) Bestandteil einer Halteeinrichtung (71) für das abgetrennte Reststück (81) des oder der Bändchen (5) bilden. Das Oberteil (65) kann hierfür ein oberes Halteelement (75), welches z.B. als mit dem Gegenhalter (76) zusammenwirkender Klemmbalken ausgebildet ist.

Beim Zusammenfahren der Kopfteile (65,66) findet zunächst ein Einspannen und ggf. Trennen des Überstands (68) statt. Das Trennelement (70) schneidet das Bändchen (5) durch, wobei das gekürzte Endstück (80) anschließend gebogen wird. Hierfür ist ein höhenbeweglicher Mitnehmer (77) vorgesehen, der z.B. die Form eines liegenden Bolzens haben kann und der am Unterteil (66) angeordnet ist. Der Mitnehmer (77) befindet sich im Freiraum zwischen der Auflage (61) und dem Trennelement (70) und kann ggf. gesteuert nach oben bewegt werden und biegt dabei das Endstück schräg nach oben.

Für die mehrstufige Bewegung des Unterteils (66) kann dieses mehrere Arme (73,74) aufweisen, die übereinander angeordnet sind und die ggf. in einer gegenseitigen Schleppverbindung stehen. Der untere Arm (74) ist z.B. mit der Zustellvorrichtung (72) verbunden und wird von dieser angetrieben. Der gleichachsig gelagerte obere Arm (73) wird hierbei über ein am unteren Arm (74) befindliches vorstehendes Federelement (78) und einen Anschlag (79) mitgenommen. Über das Federelement (78) wird zunächst der Gegenhalter (76) nach oben und in Anlage am Trenn- und Halteelement (70,75) gebracht, wobei in der weiteren Bewegung der mit dem unteren Arm (74) über einen Ausleger verbundene Mitnehmer (77) eine zusätzliche Aufwärtsbewegung ausführt und dadurch die vorbeschriebene Endstückbiegung bewirkt. Das Federelement (78) wird hierbei zusammengedrückt und anschließend der Anschlag (79) in Kontakt mit dem oberen Arm (73) gebracht, sodass die volle Zustellkraft nun zum Klemmen des Reststücks (81) und zum Abtrennen des Überstands (68) zum Einsatz kommt.

Wie Figur 12 verdeutlicht, kann am Trimmkopf (64) außerdem ein Diffusionselement (82) angeordnet sein, welches bei der Abschwenkbewegung des Oberteils (65) über das Stirnende des Strings (3) bewegt wird und zum Schließen der gesamten Diffusionseinrichtung beiträgt.

Die Trimmeinrichtung (13) ist in der gezeigten Ausführungsform mit der Prüfeinrichtung (12) kombiniert. Sie kann alternativ separat angeordnet sein. In weiterer Abwandlung kann die Trimmeinrichtung (13) ohne die beschriebene Prüfeinrichtung (12) oder in Verbindung mit einer anderen Prüfeinrichtung eingesetzt werden.

Die Serviceeinrichtung (11) und ihre Teile können eine eigenständige Steuerung aufweisen, in der auch die Auswerteeinrichtung (47) untergebracht sein kann. Diese Steuerung kann mit einer Manipulatorsteuerung (9) verbunden sein, wobei eine weitere Verbindung zu einer übergeordneten Anlagensteuerung bestehen kann. Für die Steuerung der einzelnen Abläufe kann eine SPS-Steuerung vorhanden sein. In der bevorzugten Ausführungsform hat die Robotersteuerung (9) einen erweiterten Umfang und ist direkt mit der Serviceeinrichtung (11) und ihren Komponenten verbunden, die dadurch vom Roboter (7) und seiner Steuerung (9) direkt und in gegenseitiger Abstimmung gesteuert werden. Die Robotersteuerung (9) kann ihrerseits an die übergeordnete Anlagensteuerung angeschlossen sein. Die vorbeschriebenen Komponenten der Serviceeinrichtung (11) und der Handhabungseinrichtung (2) können einzeln oder mehrfach vorhanden sein. Die jeweilige Nennung eines Teils bedeutet lediglich, dass dieses Teil grundsätzlich vorhanden ist und schließt eine Mehrfachanordnung nicht aus.

Darüber hinaus sind Abwandlungen der gezeigten und beschriebenen Ausführungsformen in verschiedener Weise möglich. Die verschiedenen Ausführungsformen und Abwandlungen können in beliebiger Weise untereinander kombiniert und vertauscht werden. Ferner können auch die Greifeinrichtung (10) und ihre Teile sowie der Manipulator (7) abgewandelt werden. Statt Sauger können andere Greifelemente zum Einsatz kommen, die auch in anderer Weise angeordnet sein können. Auch die Komponenten der Serviceeinrichtung (11) können abgewandelt werden.

Die vorbeschriebenen Ausführungsbeispiele beinhalten mehrere eigenständige Erfindungsaspekte in einer optimierten Kombination, wobei in anderen Ausführungen die Erfindungsaspekte einzeln oder in anderen Kombinationen einsetzbar sind. Die Prüfeinrichtung (12) und die Trimmeinrichtung (13) sowie die zugehörigen Verfahren haben eigenständige erfinderische Bedeutung, wobei eine andere Serviceeinrichtung (11) nur die Prüfeinrichtung (12) oder nur die Trimmeinrichtung (13) nebst zugehörigen Verfahren aufweisen kann. Ferner können die Prüfeinrichtung (12) und das Prüfverfahren in Abwandlung der vorbeschriebenen Ausführungsbeispiele nur zum Prüfen des Werkstücks (3) oder nur zum Prüfen der Handhabungseinrichtung (2) eingesetzt werden und können für diese isolierten Zwecke entsprechend reduziert und ausgebildet sein.

In einer anderen Ausführung kann sich eine Werkstückprüfung z.B. auf eine Qualitäts- und/oder Funktionsprüfung, z.B. eine optische Leuchtprüfung mit Erfassungsgerät (45), beschränken, wobei auf eine Prüfung der Form- und/oder Lagemerkmale des Werkstücks (3) verzichtet wird und die Serviceeinrichtung (11) und das Serviceverfahren eine entsprechend reduzierte Ausbildung haben. Die Referenzeinrichtung (42) kann z.B. entfallen. Auch eine umgekehrte Variante nur mit Prüfung der Form- und/oder Lagemerkmale des Werkstücks (3) ohne Qualitäts- und/oder Funktionsprüfung ist möglich. Die Greifeinrichtung (10) und deren Zusatzteile, d.h. das Diffusionselement (26), die Werkzeug-Referenzmarke (27) nebst Absteckung (30) und die Detektionseinrichtung (31) haben jeweils eigenständige erfinderische Bedeutung und können gemeinsam oder einzeln benutzt werden.

### BEZUGSZEICHENLISTE

- 1: Fertigungseinrichtung
- 2: Handhabungseinrichtung, Zuführeinrichtung
- 3: Werkstück, String, Zellenformation
- 4: Werkstückteil, Solarzelle
- 5: Werkstückteil, Verbindungselement, Bändchen
- 6: Solarelement, Photovoltaikelement
- 7: Manipulator, Roboter
- 8: Hand, Roboterhand
- 9: Steuerung, Robotersteuerung
- 10: Greifeinrichtung, Greifwerkzeug
- 11: Serviceeinrichtung
- 12: Prüfeinrichtung
- 13: Trimmeinrichtung
- 14: Stringer
- 15: Vorzentrierung
- 16: Assemblingbereich
- 17: Zuführeinrichtung, Linearroboter
- 18: Auflage
- 19: Abgabe
- 20: Anschluss
- 21: Längsachse, Längsrichtung
- 22: Deckplatte
- 23: Versorgung
- 24: Träger
- 25: Greifer, Sauger
- 26: Diffusionselement, Diffusorplatte
- 27: Werkzeug-Referenzmarke
- 28: Öffnung
- 29: Flansch
- 30: Absteckung
- 31: Detektionseinrichtung
- 32: Kalibrierteil
- 33: Korpus, Platte
- 34: Referenzmarkierung für Werkstücke
- 35: Stützelement
- 36: Verbindungselement
- 37: Referenzmarke für Greifwerkzeug
- 38: Referenzmarke für Kalibrierposition
- 39: Gehäuse
- 40: Gehäuseöffnung, Zugangsöffnung
- 41: Erfassungseinrichtung
- 42: Referenzeinrichtung
- 43: Beleuchtungseinrichtung
- 44: Versorgungseinrichtung, Stromversorgung
- 45: optisches Erfassungsgerät, Kamera, Messkamera
- 46: Sichtbereich
- 47: Auswerteeinrichtung
- 48: Fördereinrichtung
- 49: Träger
- 50: Beleuchtungsgerät unten
- 51: Beleuchtungsgerät oben
- 52: Zustelleinrichtung
- 53: Diffusionselement, Diffusorplatte
- 54: Leuchtelement
- 55: Referenzmarkierung für Werkstück
- 56: Lochleiste
- 57: Lochleiste
- 58: Loch
- 59: Referenzmarke für Kalibrierteil
- 60: Versorgungsanschluss, Stromanschluss
- 61: Auflage
- 62: Innenraum des Gehäuses
- 63: Aufnahmebereich
- 64: Trimmkopf
- 65: Kopfteil, Oberteil
- 66: Kopfteil, Unterteil
- 67: Achse
- 68: Überstand Verbindungselement
- 69: Kontaktelement, Federstößel
- 70: Trennelement, Messer
- 71: Halteeinrichtung
- 72: Zustellvorrichtung
- 73: Arm oben getrieben
- 74: Arm unten treibend
- 75: Halteelement, Klemmbalken
- 76: Gegenhalter, Schneidplatte
- 77: Mitnehmer, Bolzen
- 78: Federelement
- 79: Anschlag
- 80: Endstück
- 81: Reststück
- 82: Diffusionselement, Diffusorplatte
- 83: Arbeitsbereich

## Patentansprüche

1. Serviceeinrichtung für Handhabungseinrichtungen (2) von Werkstücken (3), insbesondere von Solarzellenanordnungen bzw. Strings, **dadurch gekennzeichnet, dass** die Serviceeinrichtung (11) eine Prüfeinrichtung (12) für die gemeinsame Prüfung des Werkstücks (3) und der Handhabungseinrichtung (2) aufweist.

2. Serviceeinrichtung nach Anspruch 1, **dadurch gekennzeichnet, dass** die Prüfeinrichtung (12) zum berührungslosen, insbesondere optischen Prüfen eines schwebend in einem Aufnahmebereich (63) gehaltenen und von außen beleuchteten und/oder selbst leuchtenden oder luminiszierenden Werkstücks (3) und/oder einer Greifeinrichtung (10) ausgebildet ist.

3. Serviceeinrichtung nach Anspruch 1 oder 2, **dadurch gekennzeichnet, dass** die Prüfeinrichtung (12) ein Gehäuse (39) mit einem Innenraum (62) und einem Aufnahmebereich (63) zur Aufnahme des Werkstücks (3) und eines Teil der Greifeinrichtung (10) sowie ein Kalibrierteil (32) für das Werkstück (3) und/oder die Greifeinrichtung (10) aufweist, wobei das Gehäuse (39) eine Zugangsöffnung (40) aufweist und gegen Lichtzutritt abdichtbar ist.

4. Serviceeinrichtung nach Anspruch 1, 2 oder 3, **dadurch gekennzeichnet, dass** die Prüfeinrichtung (12) eine optische Erfassungseinrichtung (41) für das Werkstück (3) und/oder die Greifeinrichtung (10) sowie eine zugehörige und im Erfassungsbereich der Erfassungseinrichtung (41) befindliche Referenzeinrichtung (42) aufweist.

5. Serviceeinrichtung nach einem der vorhergehenden Ansprüche, **dadurch gekennzeichnet, dass** die Prüfeinrichtung (12) eine stationäre Referenzeinrichtung (42) mit einer oder mehreren neben einem Aufnahmebereich (63) des Werkstücks (39) im Gehäuse (39) angeordneten Referenzmarkierungen (55) aufweist, wobei die Referenzeinrichtung (42) eine Referenzmarke (59) für ein Kalibrierteil (32) aufweist.

6. Serviceeinrichtung nach einem der vorhergehenden Ansprüche, **dadurch gekennzeichnet, dass** die Prüfeinrichtung (12) eine mobile Werkzeug-Referenzmarke (27) an einer Greifeinrichtung (10) aufweist.

7. Serviceeinrichtung nach einem der vorhergehenden Ansprüche, **dadurch gekennzeichnet, dass** die Serviceeinrichtung (11) eine Trimmeinrichtung (13) für Teile (5), insbesondere Verbindungselemente des Werkstücks (3), aufweist.

8. Serviceeinrichtung nach einem der vorhergehenden Ansprüche, **dadurch gekennzeichnet, dass** die Trimmeinrichtung (13) ein federnd zustellbares und gegen eine Auflage (61) für ein Werkstückteil (5) wirkendes Kontaktelement (69) aufweist.

9. Handhabungseinrichtung für Werkstücke (3), insbesondere von Solarzellenanordnungen bzw. Strings, aufweisend einen mehrachsigen Manipulator (7) mit einer Greifeinrichtung (10) für ein Werkstück (3), **dadurch gekennzeichnet, dass** im Arbeitsbereich (83) des Manipulators (7) eine Serviceeinrichtung (11) gemäß mindestens einem der Ansprüche 1 bis 8 mit einer Prüfeinrichtung (12) zur gemeinsamen Prüfung des Werkstücks (3) und der Handhabungseinrichtung (2), insbesondere des Manipulators (7) und/oder der Greifeinrichtung (10), angeordnet ist.

10. Handhabungseinrichtung nach Anspruch 9, **dadurch gekennzeichnet, dass** im Arbeitsbereich (83) des Manipulators (7) eine Serviceeinrichtung (11) mit einer Trimmeinrichtung (13) für Teile (5), insbesondere Verbindungselemente des Werkstücks (3), angeordnet ist.

11. Handhabungseinrichtung nach Anspruch 9 oder 10, **dadurch gekennzeichnet, dass** die Greifeinrichtung (10) mehrere Greifer (25), insbesondere federnde Sauger, aufweist, die entsprechend der Anordnung von Wafern (4) eines Strings (3) verteilt angeordnet sind.

12. Handhabungseinrichtung nach einem der Ansprüche 9 bis 11, **dadurch gekennzeichnet, dass** die Greifeinrichtung (10) eine obere Deckplatte (22) aufweist, mit der eine Zugangsöffnung (40) eines Gehäuses (39) verschließbar ist, und eine neben dem Werkstück (3) und etwa in dessen Höhe angeordnete Werkzeug-Referenzmarke (27) aufweist.

13. Fertigungseinrichtung für Solarelemente (6), bestehend aus einem Stringer (14) und einer Handhabungseinrichtung (2) von Solarstrings (3) mit einem mehrachsigen Manipulator (7) nebst einer Greifeinrichtung (10), wobei die Fertigungseinrichtung (1) einen Assemblingbereich (16) und eine Handhabungseinrichtung (17) für weitere Komponenten der Solarelemente (6) aufweist, **dadurch gekennzeichnet, dass** im Arbeitsbereich (83) des Manipulators (7) eine Serviceeinrichtung (11) gemäß mindestens einem der Ansprüche 1 bis 8 angeordnet ist.

14. Fertigungseinrichtung nach Anspruch 13, **dadurch gekennzeichnet, dass** die Handhabungseinrichtung (2) nach mindestens einem der Ansprüche 9 bis 12 ausgebildet ist.

15. Serviceverfahren für Handhabungseinrichtungen (2) von Werkstücken (3), insbesondere von Solarzellenanordnungen bzw. Strings, **dadurch gekennzeichnet, dass** von einer Serviceeinrichtung (11) mittels einer Prüfeinrichtung (12) das Werkstück (3) und die Handhabungseinrichtung (2) gemeinsam geprüft werden.

16. Serviceverfahren nach Anspruch 15, **dadurch gekennzeichnet, dass** mit der Prüfeinrichtung (12) Form- und/oder Lagemerkmale und/oder Qualitäts- und/oder Funktionsmerkmale des Werkstücks (3) sowie Veränderungen der Handhabungseinrichtung (2), insbesondere Schäden und/oder Positionierfehler einer Greifeinrichtung (10) und/oder eines mehrachsigen Manipulators (7), geprüft werden.

## Claims

1. Service device for handling devices (2) of workpieces (3), in particular solar cell assemblies or strings, **characterized in that** the service device (11) has a test device (12) for the joint testing of the workpiece (3) and the handling device (2).

2. Service device according to Claim 1, **characterized in that** the test device (12) is designed for the non-contact, in particular optical, testing of a workpiece (3) that is held in a floating manner in a holding area (63) and is illuminated from outside and/or is self-illuminating or is luminescent and/or of a gripping device (10).

3. Service device according to Claim 1 or 2, **characterized in that** the test device (12) has a housing (39) with an interior (62) and a holding area (63) for holding the workpiece (3) and part of the gripping device (10), as well as a calibration part (32) for the workpiece (3) and/or the gripping device (10), wherein the housing (39) has an access opening (40) and can be sealed off against the entry of light.

4. Service device according to Claim 1, 2 or 3, **characterized in that** the test device (12) has an optical detection device (41) for the workpiece (3) and/or the gripping device (10), as well as an associated reference device (42) located in the detection range of the detection device (41).

5. Service device according to one of the preceding claims, **characterized in that** the test device (12) has a stationary reference device (42) with one or more reference markings (55) arranged beside a holding area (63) of the workpiece (3) in the housing (39), wherein the reference device (42) has a reference mark (59) for a calibration part (32).

6. Service device according to one of the preceding claims, **characterized in that** the test device (12) has a mobile tool reference mark (27) on a gripping device (10).

7. Service device according to one of the preceding claims, **characterized in that** the service device (11) has a trimming device (13) for parts (5), in particular connecting elements of the workpiece (3).

8. Service device according to one of the preceding claims, **characterized in that** the trimming device (13) has a contacting element (69) that can be fed in in a sprung manner and acts against a support (61) for a workpiece part (5).

9. Handling device for workpieces (3), in particular of solar cell assemblies or strings, having a multi-axis manipulator (7) with a gripping device (10) for a workpiece (3), **characterized in that** a service device (11) according to at least one of Claims 1 to 8 having a test device (12) for the joint testing of the workpiece (3) and of the handling device (2), in particular of the manipulator (7) and/or of the gripping device (10), is arranged in the working area (83) of the manipulator (7).

10. Handling device according to Claim 9, **characterized in that** a service device (11) having a trimming device (13) for parts (5), in particular connecting elements of the workpiece (3), is arranged in the working area (83) of the manipulator (7).

11. Handling device according to Claim 9 or 10, **characterized in that** the gripping device (10) has a plurality of grippers (25), in particular sprung suckers, which are arranged to be distributed in accordance with the arrangement of wafers (4) of a string (3).

12. Handling device according to one of Claims 9 to 11, **characterized in that** the gripping device (10) has an upper cover plate (22), with which an access opening (40) of a housing (39) can be closed, and a tool reference mark (27) arranged beside the workpiece (3) and approximately at the height thereof.

13. Manufacturing device for solar elements (6), comprising a stringer (14) and a handling device (2) for solar strings (3) having a multi-axis manipulator (7) together with a gripping device (10), the manufacturing device (1) having an assembly area (16) and a handling device (17) for further components of the solar element (6), **characterized in that** a service device (11) according to at least one of Claims 1 to 8 is arranged in the working area (83) of the manipulator (7).

14. Manufacturing device according to Claim 13, **characterized in that** the handling device (2) is constructed in accordance with at least one of Claims 9 to 12.

15. Service method for handling devices (2) of workpieces (3), in particular of solar cell assemblies or strings, **characterized in that** the workpiece (3) and the handling device (2) are tested jointly by a service device (11) by means of a test device (12).

16. Service method according to Claim 15, **characterized in that** shape and/or location features and/or quality and/or functional features of the workpiece (3) as well as changes in the handling device (2), in particular damage and/or positioning errors of a gripping device (10) and/or a multi-axis manipulator (7), are tested by means of the test device (12).

## Revendications

1. Dispositif de service pour dispositifs de manipulation (2) de pièces (3), en particulier d'ensembles ou de chaînes de cellules solaires, **caractérisé en ce que**
un dispositif de service (11) présente un dispositif de vérification (12) permettant de vérifier en même temps la pièce (3) et le dispositif de manipulation (2).

2. Dispositif de service selon la revendication 1, **caractérisé en ce que** le dispositif de vérification (12) est configuré pour vérifier sans contact et en particulier optiquement une pièce (3) maintenue flottante dans une partie de réception (63) et éclairée de l'extérieur et/ou auto-luminescente ou luminescente, et/ou un dispositif de saisie (10).

3. Dispositif de service selon les revendications 1 ou 2, **caractérisé en ce que** le dispositif de vérification (12) présente un boîtier (39) doté d'un espace intérieur (62) et d'une partie de réception (63) qui reçoit la pièce (3) et une partie du dispositif de saisie (10) ainsi qu'une partie d'étalonnage (32) de la pièce (3) et/ou du dispositif de saisie (10), le boîtier (39) présentant une ouverture d'accès (40) et pouvant être protégé contre la pénétration de la lumière.

4. Dispositif de service selon les revendications 1, 2 ou 3, **caractérisé en ce que** le dispositif de vérification (12) présente un dispositif (41) de saisie optique de la pièce (3) et/ou du dispositif de saisie (10) ainsi qu'un dispositif de référencement (42) associé et situé dans la zone de saisie du dispositif de saisie (41).

5. Dispositif de service selon l'une des revendications précédentes, **caractérisé en ce que** le dispositif de vérification (12) présente un dispositif stationnaire de référencement (42) doté d'un ou plusieurs repères de référencement (55) disposés dans le boîtier (39) à côté d'une partie de réception (63) de la pièce (3), le dispositif de référencement (42) présentant un repère de référencement (59) pour une partie d'étalonnage (32).

6. Dispositif de service selon l'une des revendications précédentes, **caractérisé en ce que** le dispositif de vérification (12) présente un repère mobile (27) de référencement d'outil disposé sur un dispositif de saisie (10).

7. Dispositif de service selon l'une des revendications précédentes, **caractérisé en ce que** le dispositif de saisie (11) présente un dispositif d'ajustement (13) de pièces (5) et en particulier d'éléments de liaison de la pièce (3).

8. Dispositif de service selon l'une des revendications précédentes, **caractérisé en ce que** le dispositif d'ajustement (13) présente un élément de contact (69) qui peut être ajusté élastiquement et agissant contre un appui (61) d'une partie d'outil (5).

9. Dispositif de manipulation de pièces (3), en particulier d'ensembles ou de chaînes de cellules solaires, présentant un manipulateur multiaxe (7) doté d'un dispositif (10) de saisie d'une pièce (3), **caractérisé en ce que**
un dispositif de service (11) selon au moins l'une des revendications 1 à 8, doté d'un dispositif de vérification (12) permettant de vérifier en même temps la pièce (3) et le dispositif de manipulation (2) et en particulier du manipulateur (7) et/ou le dispositif de saisie (10) est disposé dans la zone de travail (83) du manipulateur (7).

10. Dispositif de manipulation selon la revendication 9, **caractérisé en ce qu'**un dispositif de service (11) doté d'un dispositif d'ajustement (13) de parties (5) et en particulier d'éléments de liaison de la pièce (3) est disposé dans la zone de travail (83) du manipulateur (7).

11. Dispositif de manipulation selon les revendications 9 ou 10, **caractérisé en ce que** le dispositif de saisie (10) présente plusieurs éléments de saisie (25) et en particulier des ventouses élastiques qui sont réparties en fonction de l'agencement des galettes (4) d'une chaîne (3).

12. Dispositif de manipulation selon l'une des revendications 9 à 11, **caractérisé en ce que** le dispositif de saisie (10) présente une plaque supérieure de recouvrement (22) qui permet de fermer une ouverture d'accès (40) à un boîtier (39) et qui présente un repère (27) de référencement d'outil disposé à côté de la pièce (3) et sensiblement à sa hauteur.

13. Dispositif de fabrication d'éléments solaires (6), constitué d'un ensemble (14) de formation de chaînes et d'un dispositif (2) de manipulation de chaînes solaires (3), présentant un manipulateur multiaxe (7) en plus d'un dispositif de saisie (10), le dispositif de fabrication (1) présentant une zone d'assemblage (16) et un dispositif de manipulation (17) des autres composants des éléments solaires (6),
**caractérisé en ce que**
un dispositif de service (11) selon au moins l'une des revendications 1 à 8 est disposé dans la zone de travail (83) du manipulateur (7).

14. Dispositif de fabrication selon la revendication 13, **caractérisé en ce que** le dispositif de manipulation (2) est configuré selon au moins l'une des revendications 9 à 12.

15. Procédé de service de dispositifs de manipulation (2) de pièces (3), en particulier d'ensembles de chaînes de cellules solaires, **caractérisé en ce que** la pièce (3) et le dispositif de manipulation (2) sont vérifiés en même temps par le dispositif de service (11) au moyen d'un dispositif de vérification (12).

16. Procédé de service selon la revendication 15, **caractérisé en ce que** le dispositif de vérification (12) vérifie des caractéristiques de forme et/ou de position, des caractéristiques de qualité et/ou des caractéristiques fonctionnelles de la pièce (3) ainsi que des modifications du dispositif de manipulation (2), en particulier des dommages et/ou des erreurs de position d'un dispositif de saisie (10) et/ou d'un manipulateur multiaxe (7).
